(19) Europäisches Patentamt / European Patent Office / Office européen des brevets

(11) **EP 3 282 474 B1**

(12) **EUROPEAN PATENT SPECIFICATION**

(45) Date of publication and mention
of the grant of the patent:
**04.08.2021 Bulletin 2021/31**

(51) Int Cl.:
*H01L 21/67* (2006.01)  *H01L 21/677* (2006.01)

(21) Application number: **17185497.9**

(22) Date of filing: **09.08.2017**

(54) **METHOD FOR PERFORMING A WET TREATMENT OF A SUBSTRATE**

VERFAHREN ZUR DURCHFÜHRUNG EINER NASSBEHANDLUNG EINES SUBSTRATS

PROCÉDÉ DE TRAITEMENT HUMIDE D'UN SUBSTRAT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **11.08.2016 EP 16183683**

(43) Date of publication of application:
**14.02.2018 Bulletin 2018/07**

(73) Proprietor: **IMEC vzw**
**3001 Leuven (BE)**

(72) Inventor: **Mertens, Paul**
**3001 Leuven (BE)**

(74) Representative: **Patent Department IMEC**
**IMEC vzw**
**Patent Department**
**Kapeldreef 75**
**3001 Leuven (BE)**

(56) References cited:
**US-A1- 2010 122 711    US-A1- 2013 081 301
US-A1- 2014 144 462**

**Description**

**Technical field of the invention**

The present invention is related to the field of cleaning in semiconductor device fabrication. More specifically, the present invention relates to the field of wet treatment of semiconductor substrates.

**Background of the invention**

In semiconductor device fabrication, a cleaning process is carried out in order to remove contaminants, etch by-products from the surface of the substrate, which could otherwise jeopardize the functioning or reliability of the devices. Typically, the cleaning step involves subjecting the substrate to different chemicals in liquid form, which have capacity to remove the contaminants or etch by-products from the surface. The cleaning process is, typically, followed by a rinsing process done by using a rinsing liquid to remove the chemicals and a drying process to remove the rinsing liquid.

In semiconductor device fabrication, the trend of reducing the size of device features is continuing. The motivation of reducing the device features is driven by the demand for improvements in the ratio of electronic circuit performance versus circuit cost. The performance improvements are for example, increased circuit speed or reduced power consumption.

As a result of the feature scaling, at intermediate stages of the fabrication process the circuits contain narrow gaps between rather flexible and fragile features having high aspect ratios, such as active area fin-structures, as well as dielectric features as parts of the isolation between different narrow metal interconnecting lines. At these intermediate steps, such features having narrow gaps in between them need to be exposed to liquids for cleaning, surface modification or surface etching. The capillary forces of the liquid cause these high-aspect ratio structures to bend and stick to each other during the drying step. This results in failure of the circuit under construction.

Furthermore, semiconductor device fabrication technologies are becoming practical for the fabrication of micro- and nano-electro-mechanical systems (MEMS and NEMS), which are used for various purposes. Thus, stiction problems occurring during the etching or cleaning process also poses a challenge for their fabrication.

One way of carrying out a cleaning process accompanied by a drying process that avoids the problem of stiction is disclosed in US 2014/0144462 A1. A method of cleaning a substrate is disclosed, whereby substrate is dried by delivery of a supercritical fluid to the surface of the substrate. Although supercritical drying may prevent stiction, it requires the use of high pressure systems suited for handling or creating supercritical fluids, which then may pose further challenges and which may even make such system undesirable due to the extra measures that need to be taken.

Another way of carrying out a cleaning process accompanied by a drying process that avoids the problem of stiction is disclosed in US 2010/0122711 A1. A wet clean method for semiconductor device fabrication is disclosed that begins by providing a semiconductor device structure having a substrate and features protruding from the substrate. The method continues by cleaning the semiconductor device structure with an aqueous solution followed by cleaning step displacing the aqueous solution with a first solvent. The features are then exposed to a second solvent that contains a hydrophobic treatment agent that reacts with the sidewalls of the features to from a hydrophobic layer on the sidewalls.

Stiction-free drying of high aspect ratio devices is also disclosed in US 2013/0081301 A1. The disclosed method relies on the use of a low surface tension drying liquid which also exhibits a high evaporation rate. The method also relies on a technique by which the drying liquid is applied. Increasing the evaporation rate of the drying liquid and application of the drying liquid in the form of a vapor helps to eliminate stiction.

It is an advantage of the embodiments of the present invention that the method allows for cleaning substrates or structures without the need to use a supercritical fluid.

It is an advantage of the embodiments of the present invention that the method allows for wet processing and subsequent drying of substrates or structures without the need to use a supercritical fluid.

It is an advantage of the embodiments of the present invention that the method allows for cleaning substrates or structures without the need for forming a hydrophobic layer on substrates or structures.

The above objective is accomplished by a method according to the present invention.

In a first aspect, the present invention relates to a method for performing a wet treatment of a structure. The method comprises obtaining a structure comprising a first surface comprising a feature fixed at least at a fist end to the first surface from which it protrudes. A sidewall of the feature faces and is positioned away from a second surface by a gap g. A wet treatment of the structure is performed. Performing the wet treatment comprises rinsing the structure by exposing it to a rinsing liquid comprising water. Subsequently, the structure is exposed to a sequence of liquids, wherein a first liquid of the sequence is miscible with the rinsing liquid and a last liquid of the sequence makes a contact angle of about 90° with the second surface and the sidewall, wherein each of the liquids in the sequence is miscible with the preceding one, and whereby at least the first surface of the structure remains covered with the rinsing liquid until exposure to the sequence and with each liquid of the sequence until exposure to a subsequent liquid in the sequence. Subsequent to performing the wet treatment, the structure is dried. The inventor realized that the presence of rinsing liquid comprising water on the structure leads to stiction during drying. Thus, the invention originates from the realization by the inventor that the use of the last liquid that makes a contact angle of about 90° with the second surface and the sidewall assures non-stiction when it is dried off from the surface.

The present invention also takes advantage of the fact that at least the first surface of the structure is kept fully covered with the rinsing liquid until exposure to the sequence and that the first liquid of the sequence is miscible with the rinsing liquid. Furthermore, the fact that the structure is subsequently fully covered with each liquid of the sequence until exposure to a subsequent liquid in the sequence, of which each of the liquids is miscible with the preceding one, leads to the fact that the structure comes into contact with the surrounding atmosphere, which is typically air, only when being dried off the last liquid therefore, resulting in non-stiction of the features.

Thus, the present invention is characterized in that a first liquid of the sequence is miscible with the rinsing liquid and a last liquid of the sequence makes a contact angle of about 90° with the second surface and the sidewall, wherein each of the liquids in the sequence is miscible with the preceding one, and whereby at least the first surface of the structure remains covered with the rinsing liquid until exposure to the sequence and with each liquid of the sequence until exposure to a subsequent liquid in the sequence.

In embodiments, performing the wet treatment may consist of rinsing the structure by exposing it to a rinsing liquid comprising water and subsequent to exposure of the structure to the rinsing liquid, exposing the structure to the sequence of liquids. In these embodiments, the structure may be dried subsequent to exposure of the structure to the sequence of liquids.

In embodiments, the contact angle may be in a range of 85° and 95° with the second surface and the sidewall.

In embodiments, the contact angle may be 90°.

In embodiments, the wet treatment may be performed at a pressure in the range of 0.5 bar to 2 bar and at a temperature in the range of 10 °C to 30 °C.

It is an advantage according to embodiments of the invention that, the wet treatment is carried out without the need for high pressure or high temperature processes or equipment. This reduces manufacturing cost and allows for providing an easy wet treatment process.

In embodiments, the exposure of the structure to the sequence may be initiated by bringing the first liquid in contact with the rinsing liquid and subsequently, replacing the rinsing liquid, gradually, by the first liquid.

It is an advantage of the embodiments of the present invention that by bringing the first liquid in contact with the rinsing liquid, a liquid mixture is formed. By replacing the rinsing liquid gradually by the first liquid, the concentration of the rinsing liquid gradually decreases to a negligible level, thereby the rinsing liquid is smoothly removed away from the structure and replaced by the first liquid. Furthermore, the gradual replacement of the rinsing liquid is, thus, performed in-situ having the advantage of ease of processing without transfers, which may in certain instances require additional precautions to be implemented.

In embodiments, the exposure of the structure to the sequence may comprise bringing a liquid in the sequence in contact with the subsequent liquid in the sequence and subsequently, replacing the liquid, gradually, by the subsequent liquid.

It is an advantage of the embodiments of the present invention that bringing each of the liquids in the sequence in contact with the subsequent one, whereby each of the subsequent liquids in the sequence is miscible with the preceding one helps to replace each liquid in a smooth and gradual way. The concentration of each of the liquids decreases to a negligible level through the gradual replacement. Furthermore, this gradual replacement prevents the structure to come into contact with air, thus overcoming stiction to occur.

In embodiments, the last liquid may be a non-polar solvent when at least the sidewall and the second surface is a polar material.

In alternative embodiments, the last liquid may also be a polar solvent when at least the sidewall and the second surface is a non-polar material.

It is advantageous that in these embodiments contact angle of about 90° is reached, thus overcoming stiction.

In embodiments, the non-polar solvent of the last liquid may be an alkane, cycloalkane or an aromatic hydrocarbon. It is advantageous such that the alkane, cycloalkane or the aromatic hydrocarbon have the potential to make a contact angle of about 90° with the second surface and the sidewall of the feature when they are hydrophilic.

In embodiments, the non-polar solvent of the last liquid may be selected from a group consisting of heptane, hexane, pentane, benzene, cyclohexane, (2,2,4)-trimethylpentane and toluene.

It is advantageous that heptane, hexane, pentane and benzene are solvents consisting of carbon and hydrogen having potential of making a contact angle of 90° with the second surface and the sidewall of the feature.

In embodiments, the non-polar solvent may be any mixture of heptane, hexane, pentane, benzene, cyclohexane, (2,2,4)-trimethylpentane and toluene.

In embodiments, the polar solvent forming the last liquid may comprise water.

It is advantageous that the polar solvent of the last liquid may comprise water for cases when at least the sidewall and the second surface is a non-polar material; for example where it is a hydrophobic surface.

In embodiments, the polar solvent forming the last liquid may consist of only water.

Yet, in embodiments, the polar solvent forming the last liquid may be de-ionized water and as such it is a readily available chemical in a cleanroom environment of semiconductor manufacturing.

In embodiments, the first liquid may be a polar solvent.

It is advantageous according to embodiments of the present invention that the first liquid may be a polar solvent so that it can be mixed with the rinsing liquid. Upon exposure of the rinsing liquid to the first liquid a mixture is formed and subsequently, the rinsing liquid can be displaced gradually and without leading to phase separation.

In embodiments, the polar solvent forming the first liquid may be an alcohol, a carboxylic acid, an amide, an organosulfur compound or an organo-halogen compound.

It is advantageous according to embodiments of the present invention that the alcohol, the carboxylic acid, the amide, the organosulfur compound or the organohalogen compound are capable of being mixed with the rinsing liquid.

In embodiments, the polar solvent of the first liquid may be selected from a group consisting of methanol, ethanol, isopropanol, dimethylformamide, methanoic acid, ethanoic acid, propanoic acid, butanoic acid, pentanoic acid and dimethylsulfoxide.

It is advantageous that the first liquid may be selected from this group due to their viscosity values that do not retard the liquid flow. Additionally, they are advantageous due to their miscibility with water such that phase separation does not occur, thus, avoiding further possibility of contamination during the wet treatment.

Additionally, they are advantageous since they avoid stiction during the wet treatment.

In embodiments, the viscosity of the first liquid may be in the range 1E-4 to 5E-3 Pa.second
In embodiments, the wet treatment may be performed in a single recipient.

It is advantageous to perform the set treatment in the single recipient, since transfer of the structure between equipments or between different chambers of an equipment is, thus, avoided. This makes the wet treatment easy to perform within a short overall process time.

In the case of hydrophilic gap walls, it is advantageous to remove water from the liquids in contact with the substrate. To obtain this the ambient (gas) inside the recipient or anywhere where in contact with the liquids should be kept essentially free of water vapour. In embodiments, the single recipient may be arranged such that the molar fraction of water inside the gas ambient in the single recipient is lower than 0.01 %.

In embodiments, the single recipient may be a tank, whereby the structure remains immersed in the tank during the wet treatment.

It is advantageous that a tank is capable of providing the conditions that the structure may be kept fully immersed in the liquids used during the wet treatment according to embodiments of the present invention.

In embodiments, the tank may be an overflow tank.

In embodiments, the wet treatment may be performed, in the single recipient, by a spraying process. The spray deposits fine droplets of liquid onto the substrate in sufficient quantity that nowhere it gets dry. The liquid is moved along the surface by gravitational force or by inertial forces (e.g. rotation of the substrate around an axis perpendicular to the plane of the surface). Excess liquid may be drained off through the outlet of the single recipient.

In embodiments, the spraying process may be done in a spray tool.

In embodiments, the spraying may be done in a rotational spray tool.

It is an advantage according to embodiments of the present invention that when the wet treatment by the spraying process is performed in a spray tool, the amount of liquids to be used and to be disposed of is reduced.

In embodiments, the sequence may consist only of a first liquid and a last liquid.

It is an advantage that by using a first liquid and a last liquid in the sequence according to embodiments of the present invention, an efficient and a fast way of wet treatment of a structure may be obtained. A sequence consisting only of the first liquid and the last liquid may result in reduction of cycle time and thus increasing throughput of the wet treatment process.

Additionally, a sequence consisting only of the first liquid and the last liquid may result in a reduction of process time.

In embodiments, the feature may be free at a second end opposite to the first end.

In embodiments, this feature may be a fin structure.

It is advantageous that the wet treatment method according to the embodiments of the present invention may be applicable for obtaining high-aspect ratio features such as fin structures that are used for the manufacturing of fin-type transistors (finFETs) or for obtaining dielectric features for the manufacturing of back-end-of-line (BEOL) structures, which are features that may be free at a second end opposite to the first end.

In embodiments, the height of the fin structure may be in the range of 50 nm to 500 nm.

In embodiments, the width, or in other words the thickness, of the fin structure may be in the range of 5 nm to 30 nm.In alternative embodiments, this feature may be a cantilever beam.

Furthermore, it is advantageous that the wet treatment method according to the embodiments of the present invention may be applicable for the manufacturing of cantilever beams, which are features that may also be free at a second end opposite to the first end.

In these embodiments, the length of the cantilever beam may be in the range of 50 nm to 1E+6 nm.

In these embodiments, the length of the cantilever may also be in the range of 50 nm to 5E+6 nm.

In these embodiments, the width, or in other words the thickness, of the cantilever beam may be in the range of 30 nm to 1E+4 nm.

In these embodiments, the gap g may be in the range of 30 nm to 1E+4 nm.

In these embodiments, the gap g may be in the range of 30 nm to 5E+4 nm.

In yet alternative embodiments, this feature may be a MEMS device or a MEMS resonator.

In embodiments, the feature may be fixed at a second surface at a second end opposite to the first end.

In these embodiments, the feature may be a bridge beam.

In embodiments, the second surface may be a sidewall of another feature protruding from the first surface.

In these embodiments, both the feature and the another feature may be fin structures.

In these embodiments, the height of the fin structures may be in the range of 50 nm to 500 nm.

In these embodiments, the width, or in other words the thickness, of the fin structures may be in the range of 5 nm to 30 nm.

In these embodiments, the gap g between the fin structures may be in the range of 3 nm to 50 nm.

It is advantageous that the wet treatment method according to the embodiments of the present invention may be applicable for obtaining high-aspect ratio features such as fin structures that are used for the manufacturing of fin-type transistors (finFETs) or for obtaining dielectric features for the manufacturing of back-end-of-line (BEOL) structures, where the second surface may be a sidewall of this another- feature protruding from the first surface that may be comprised in a plurality of fin structures or plurality of dielectric features.

In embodiments, the aspect ratio of the fin structures may be in the range of 1 to 100.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices and methods in this field, the present concepts are believed to represent substantial new and novel improvements, including departures from prior practices, resulting in the provision of more efficient, stable and reliable devices or methods of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention which is defined by the appended claims. The reference figures quoted below refer to the attached drawings.

**Brief description of the figures**

**Fig. 1a** is a flowchart representing a method according to an embodiment of the present invention.
**Fig. 1b** is a flowchart showing the sub-steps of the wet treatment process of the method of the present invention.
**Fig. 1c** shows the forces acting on features that result in stiction.
**Fig. 1d** shows a tilted cross section Scanning Electron Microscopy (X-SEM) image of features suffering from stiction problem.
**Fig. 2a and Fig. 2b** show features as being fin structures to which the present invention may be applicable for.
**Fig. 3a and Fig.3b** show features as being a cantilever beam to which the present invention may be applicable for.
**Fig. 4a and Fig. 4b** shows features as being a MEMS resonator or a bridge beam to which the present invention may be applicable for.

The figures are only schematic and are non-limiting. In the drawings, the size of some of the elements may be exaggerated and not drawn on scale for illustrative purposes. Any reference signs in the claims shall not be construed as limiting the scope. In the different drawings, the same reference signs refer to the same or analogous elements.

**Detailed description of the invention**

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

It is to be noticed that the term *"comprising",* used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof.

Reference throughout the specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout the specification are not necessarily all referring to the same embodiment, but may. Furthermore, the particular features, structures or characteristics may be combined in any suitable manner, as would be apparent to one of ordinary skill in the art from the disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. The method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into the detailed description, with each claim standing on its own as a separate embodiment of the invention.

Furthermore, while some embodiments described herein include some but not other features included in other embodiments, combinations of features of different embodiments are meant to be within the scope of the invention, and form different embodiments, as would be understood by those skilled in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of the description.

The following terms are provided solely to aid in the understanding of the invention.

As used herein and unless provided otherwise, *"rinsing"* refers to removal of contaminants or etch by-products using liquids.

As used herein and unless provided otherwise, *"rinsing liquid"* refers to the liquid, liquids or mixture of liquids used in the rinsing process.

As used herein and unless provided otherwise, *"cycle time of a process"* refers to the period required to complete the wet treatment process from start to finish.

As used herein and unless provided otherwise, *"throughput"* refers to productivity of a process expressed over a unit period. It indicates how many substrates can be treated per unit time.

As used herein and unless provided otherwise, *"subsequent liquid"* refers to the *following liquid* or to the *succeeding liquid* such that it is the liquid used in the sequence at later moment in time.

As used herein and unless provided otherwise, *"preceding liquid"* refers to the liquid that is used at an earlier moment in time in the sequence compared to the subsequent liquid. It may also refer to the liquid being present in the wet treatment environment at an instantaneous moment in time just before the introduction of the subsequent liquid into the wet treatment environment.

As used herein and unless provided otherwise, *"stiction"* refers to the phenomenon of failure where a part of the feature and a part of the second surface that faces the part of the feature are joined together. The joined parts may be located towards one end or in a central region of the feature and the second surface.

As used herein and unless provided otherwise, *"aromatic hydrocarbon"* refers to a hydrocarbon, which is an organic compound consisting entirely of hydrogen and carbon atoms, with sigma bonds and delocalized pi electrons between carbon atoms forming rings.

As used herein and unless provided otherwise, *"an overflow tank"* refers to a tank which has a fluid inlet and outlet and whereby a continuous flow is obtained inside the tank by the fluid entering from the inlet and exiting the tank from the outlet. In some other instances, there is only an inlet, which is located at the bottom of the tank and the fluid exits the tank from above by overflowing due to the continuous flow provided through the inlet.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

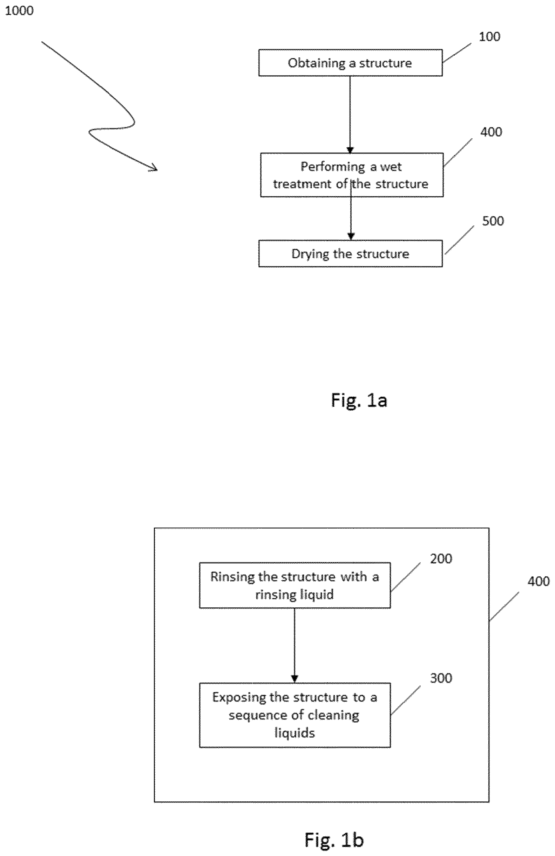

We now refer to **Figure 1a** showing a flowchart of performing a wet treatment of a structure.

The method (1000) starts with obtaining a structure (100, 110, 120, 130, 140, 150). The structure (100, 110, 120, 130, 140, 150) may comprise a substrate (20,21).

In embodiments, this structure may already have gone through an etch process and a cleaning process, which is done to remove contaminants or etch by-products from the surface of the structure.

In embodiments, the substrate may include any underlying material or materials that may be used, or upon which a device may be formed.

In embodiments, the substrate (20,21) may be a semiconductor substrate suitable for manufacturing semiconductor devices. The semiconductor substrate may be a bulk semiconductor substrate, such as for example, Si, Ge, gallium arsenide (GaAs), a gallium arsenide phosphide (GaAsP), an indium phosphide (InP) or a silicon germanium (SiGe) substrate. In embodiments, the substrate may be an oxide or a nitride.

In embodiments, the substrate (20,21) may comprise different semiconductor layers stacked on top of one another, such as for example silicon germanium (SiGe) vs. germanium (Ge) or silicon (Si) vs. silicon germanium (SiGe).

In embodiments, the substrate (20,21) may include for example an insulating layer such as silicon oxide, for example $SiO_2$, or a silicon nitride, for example $Si_3N_4$, layer in addition to a semiconductor substrate portion. Thus, the substrate may also be silicon-on-glass, silicon-on sapphire, silicon-on-insulator (SOI) substrate or germanium-on-insulator (GeOI) substrate.

In embodiments, the substrate (20,21) may be a dielectric substrate such for example a high-k dielectric or low-k dielectric, wherein k stands for the relative dielectric constant.

In embodiments, the substrate may comprise a dielectric layer.

In embodiments, the substrate (20,21) may be a metal substrate.

In embodiments, the substrate (20,21) may comprise a metal layer.

In embodiments, the structure (100, 110, 120, 130, 140,150) may comprise a first surface (5,5',5"). The first surface (5, 5',5") may comprise a feature (10,11,30,40) fixed at least at a first end to the first surface (5, 5',5") and the feature (10,11,30,40) may protrude from the first surface (5, 5',5").

In embodiments, the feature may be a free standing feature. The free standing feature may be unsupported at least from the sides of its main body.

In embodiments, the feature (10,11,30,40) may be formed or patterned in the substrate (20,21) or in the semiconductor, dielectric or metal layer comprised in the substrate (20,21). Thus, in embodiments, the feature (10,11,30,40) may be formed or patterned in the semiconductor substrate, in the dielectric substrate, in the metal substrate.

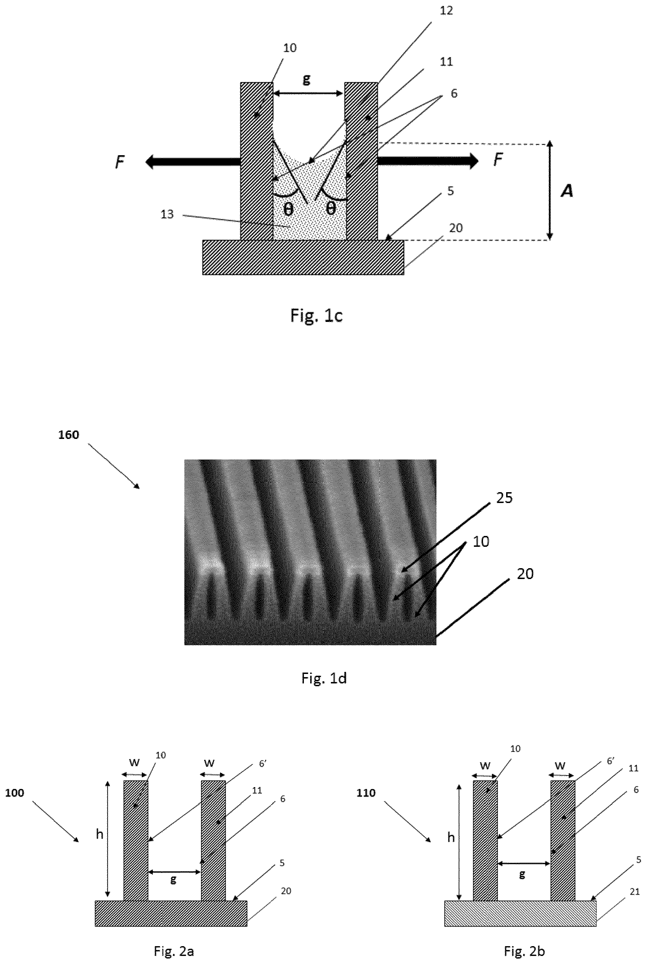

We now refer to **Fig. 2, Fig. 3, Fig. 4** showing different alternatives of the feature.

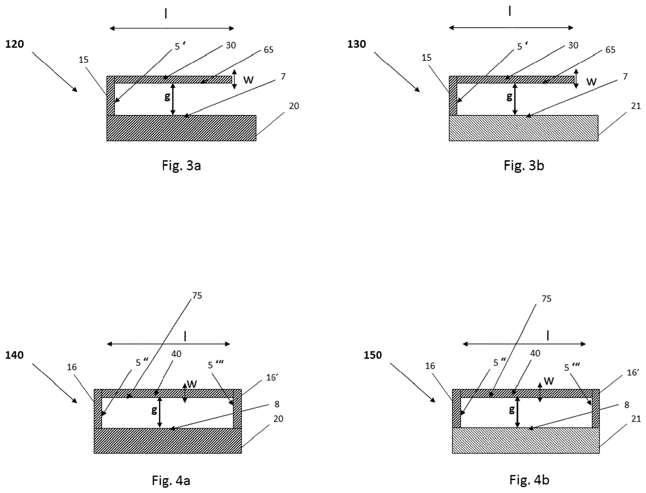

In embodiments, the feature (10,11,30,40) may be fixed at least at a first end to the first surface (5,5',5") and may protrude perpendicularly and extend away from the first surface (5,5',5"). In embodiments, the feature (10,11,30) may be free at a second end opposite to the first end (**Fig. 2 and Fig. 3**). Thus, in these embodiments, the feature is unsupported from the sides of its main body and unsupported at the second end. In embodiments, the feature (40) may also be fixed at the second end (**Fig. 4**). In these embodiments, the feature is unsupported only from the sides of its main body.

In embodiments, the first surface (5) may be comprised in a upper main surface of the substrate (20, 21) (**Fig. 2a; Fig. 2b**). The upper main surface not covered by the protruding feature (10,11) may be exposed to the surrounding environment or ambient.

In these embodiments, the feature (10,11) may be located within a plurality of parallel free-standing features or may be one of the features located on either end of the plurality of features, whereby a sidewall (6') of the feature may be positioned away from a second surface (6) by a gap having a width of g. The second surface (6) may, in these embodiments thus, be a sidewall surface of a neighboring feature (11), which may identically be the same as the feature (10) itself.

In these embodiments, the feature (10,11) may be a fin structure.

In these embodiments, the gap having the width of g may be in the range of 5 nm to 30 nm.

In these embodiments, the fin structure (10,11), may be used for the making of fin-type transistors, and may consist of or comprise a semiconductor material.

In alternative embodiments, the fin structure (10,11), may be used to separate interconnect lines in the back-end-of-line (BEOL) of semiconductor manufacturing, and may consist of or comprise a dielectric material. This dielectric material may be silicon oxide or a low-k dielectric material, which has a k-value lower than that of silicon oxide. The silicon oxide may, preferably, be silicon dioxide. The fin structure (10,11) may also consist of or comprise a metal.

We now refer to **Fig. 3a and Fig. 3b,** where in embodiments, the feature (30) may be fixed at least at a first end to the first surface (5'), may protrude perpendicularly and may extend away from the first surface (5') and may be free at a second end opposite to the first end. In these embodiments, the first surface (5') may be comprised in a support feature (15) formed on the upper main surface of the substrate (20,21) and the feature (30) may protrude perpendicularly and extend away from the first surface (5') of the support feature (15). A sidewall (65) of the feature may be positioned away from a second surface (7) by a gap having a width of g. The second surface (7) may, in these embodiments, thus be comprised in the upper main surface of the substrate (20,21) such that the first surface (5') may be perpendicular to the second surface (7) and thus the feature (30) may be suspended over and lie parallel to the second surface (7). The support feature (15) may be made of the same material as the substrate and/or the feature.

In embodiments, referring to **Fig 3a and Fig. 3b,** the feature (30) may be a cantilever beam.

In these embodiments, the length (l) of the cantilever beam (30) may be in the range of 50 nm to 1E+6 nm.

In these embodiments, the width (w), or in other words the thickness, of the cantilever beam (30) may be in the range of 30 nm to 1E+4 nm.

In these embodiments, referring to Fig. 3a and Fig. 3b, the gap g may be in the range of 30 nm to 1E+4 nm.

Referring to **Fig. 4a and Fig. 4b,** in embodiments, the feature (40) may be fixed at least at a first end to the first surface (5") of the structure (140, 150) and may also be fixed at a second end to another surface (5''') opposite to the first surface (5") of the structure (140, 150). In these embodiments, the first surface (5") and the another surface (5''') may be comprised in anchors (16, 16') to be used for attaching the feature (40) to the substrate (20). The anchors (16, 16') may be identical or different. The sidewall (75) of the feature (40) that faces the second surface (8) may be positioned away from this second surface (8) by a gap having a width of g, whereby the feature (40) may, thus, be suspended over and lie parallel to the second surface (8). The second surface (8) may be comprised on an upper main surface of the substrate (20,21).

In embodiments, referring to **Fig 4a and Fig. 4b,** the feature (40) may be a MEMS resonator.

In alternative embodiments referring to **Fig 4a and Fig. 4b,** the first surface (5") and the another surface (5''') opposite to the first surface may be comprised in support beams, or in other words anchors, (16, 16')). In these alternative embodiments, the first surface (5") and the another surface (5''') may be comprised in the support beams (16, 16')) and may face each other. The support beams (16, 16')) may be formed on the substrate (20) protruding perpendicularly and extending away from the upper main surface of the substrate (20,21) . The second surface (8) may be comprised on an upper main surface of the substrate (20) and may be bounded by the support beams (16, 16')). The support beams (16, 16')) may be separated from each other by a distance equal to the length (l) of the feature (40). The sidewall (75) of the feature (40) that faces the second surface (8) may be positioned away from the second surface (8) by a gap having a width of g, whereby the feature (40) may, thus, be suspended over and lie parallel to the second surface (8).

In these alternative embodiments, referring to **Fig 4a and Fig. 4b,** the feature (40) may be a bridge beam.

The bridge beam (40) may be fixed at a second end, opposite to the first end to another surface (5''') as well as at the first end.

In embodiments, the length (l) of the bridge beam (40), extending from the first end to the second end, may be in the range of 50 nm to 1E+6 nm.

In embodiments, the width (w), or in other words the thickness, of the bridge beam may be in the range of 30 nm to 1E+4 nm.

In embodiments, the gap g between the bridge beam may be in the range of 30 nm to 1E+4 nm.

In embodiments, the cantilever beam, MEMS resonator or bridge beam may be formed as known to persons skilled in the art, which typically involves etching a sacrificial layer, thereby releasing or in other words forming the cantilever beam, MEMS resonator or bridge beam. The method according to embodiments of the present invention is advantageous for performing the wet treatment of structures such as cantilever beams, MEMS resonators or bridge beams thereby avoiding stiction of such features (10,11,30,40) to the second surface (7,8).

In embodiments where the feature (10,11,30,40) may be formed or patterned in the substrate (20,21), both the feature (10,11,30,40) and the substrate (20) may be of the same material as shown in **Fig.2a, Fig.3a, and Fig. 4a.**

In embodiments where the feature (10,11,30,40) may be formed or patterned in a layer comprised in the substrate (20,21), the feature (10,11,30,40) and the substrate (21) may be of different material as shown in **Fig.2b, Fig.3b, and Fig. 4b.** The layer may be a semiconductor layer, a dielectric layer, or a metal layer. The semiconductor layer, dielectric layer or the metal layer may further be comprised of a stack of layers. Obtaining features (10,11,30,40) in a layer comprised in the substrate is known to persons skilled in the art.

We now refer back to **Figure 1a together with Figure 1b,** where the structure (100,110,120,130,140,150) is wet cleaned (400). Wet treatment comprises rinsing (200) the structure (100,110,120,130,140,150) followed subsequently by exposing (300) the structure to a sequence of liquids (**Fig. 1b**).

In embodiments, the wet treatment (400) may be carried out in a wet treatment environment. The wet cleaning environment, in embodiments of the present invention, may be a single recipient. This single recipient may be a tank. This tank may be an overflow tank. In embodiments, the wet treatment may be performed, in the recipient, by a spraying process. Thus, this single recipient, may thus be a spray tool. It is advantageous to carry out the wet treatment in the overflow tank or in the spray tool since the structure will remain fully immersed in the liquids in the tank or be fully covered with the liquids in the spray tool during exposure to the rinsing liquid and to the subsequent sequence of liquids. It is necessary that the structure does not come into contact with the ambient, for example air, until it is exposed to the last liquid of the sequence since this advantageously allows for wet treatment without stiction problem to occur.

In embodiments, the structure (100,110,120,130,140,150) may be placed in the overflow tank or in the spray tool individually. In alternative embodiments, the structure (100,110,120,130,140,150) may be placed in the overflow tank or in the spray tool within a batch that consists of other identical structures depending on the overflow tank design or the spray tool design.

In embodiments, the single recipient may comprise a means for heating the structure. The means for heating the structure may, for example, be a heater or it may, for example, be the stage on which the structure is placed inside the single recipient. The structure may be gradually heated from an ambient temperature inside the single recipient to a temperature up to 40 °C. This avoids condensation of any vapor that may possibly be present inside the single recipient. Furthermore, the last liquid should also be volatile, therefore, heating the structure towards the end of the drying process helps to remove the residues of the last liquid by evaporation.

The rinsing liquid comprises water. Water is typically used and readily available in cleanroom environments, where semiconductor manufacturing is taking place.

In embodiments, the rinsing liquid comprising water may further comprise dissolved oxygen.

In embodiments, the rinsing liquid may consist of water and less than 1 ppb of molecular oxygen.

In embodiments, the rinsing liquid may consist of water and less than 1 ppb of hydrogen peroxide.

It is advantageous to keep the oxygen or hydrogen peroxide concentration less than 1 ppb in order to avoid stiction.

Preferably, the rinsing liquid may consist of water.

Wet treatment carried out in the overflow tank may be such that rinsing may include immersing the structure in the rinsing liquid in the overflow tank and then providing a continuous flow of the rinsing liquid. The continuous flow of the rinsing liquid may be provided through an inlet located at the top or at the bottom of the tank enclosure. The inlet located at the top or at the bottom of the tank enclosure provides complete passage of the liquids used in the wet cleaning process through the tank enclosure and eventually getting drained out of the tank enclosure. On the other hand, wet cleaning carried out in a spray tool may be such that rinsing may include spraying the structure continuously with the rinsing liquid, whereby the structure is placed in the spray tool such that at least its first surface gets and remains in contact with the rinsing liquid.

Subsequent to the rinsing (200), the structure (100,110,120,130,140,150) may be exposed (300) to a sequence of liquids (**Fig. 1b**).

In embodiments, the exposure of the structure (100,110,120,130,140,150) to the sequence may be initiated by bringing the first liquid of the sequence in contact with the rinsing liquid. Bringing the first liquid in contact with the rinsing liquid may be done by feeding the first liquid into the inlet of the overflow tank, through which the rinsing liquid has been flowing.

Feeding the first liquid into the inlet may be done by stopping the flow of the rinsing liquid and simultaneously starting the flow of the first liquid into the inlet so that a continuous flow is maintained.

Feeding the first liquid into the inlet may also be done by gradually introducing the first liquid into the same inlet together with the rinsing liquid and then gradually stopping the flow of the rinsing liquid.

Feeding the first liquid into the inlet may further be done by gradually introducing the first liquid into the over flow tank through a second inlet and then stopping the flow of the rinsing liquid gradually either starting at the same time as the introduction of the first liquid or after a certain amount of time elapses since the introduction of the first liquid.

The second inlet may be located on the same side of the tank as that of the inlet for the rinsing liquid.

Thanks to the miscibility of the rinsing liquid and first liquid a gradual shift from the rinsing liquid to the first liquid will be easier and without phase separation, which otherwise may cause undesired problems. Subsequently, the rinsing liquid may be displaced gradually from the wet treatment environment due to the continuous flow of the first liquid into the over flow tank. The time it takes for the displacement of the rinsing liquid from the over flow tank and having it replaced by the first liquid may depend on factors such as the volume or the size of the overflow tank and, the flow rate of the first liquid.

A similar principle of working may be implemented in a spray tool, whereby it is the first surface of the structure that faces the spray inlet(s) and that remains covered by the rinsing liquid, by the mixture of the rinsing liquid with the first liquid or by the first liquid as a function of time of bringing the first liquid in contact with the rinsing liquid.

In embodiments, the first liquid may be a polar solvent. This is advantageous since it will help the first liquid mix with the rinsing liquid, wherein the rinsing liquid comprises water. In embodiments, it is also advantageous, in terms of miscibility, to have a polar solvent as the first liquid where the rinsing liquid consists of water or consists of water and dissolved oxygen. Miscibility of the first liquid with the rinsing liquid is essential thus, avoiding phase separation and therefore, performing an efficient wet treatment process.

The polar solvent of the first liquid may be an alcohol, a carboxylic acid or an amide. Carboxylic acids up to five carbon atoms, or alcohols up to three carbon atoms are soluble with the rinsing liquid. In embodiments, the first liquid may be selected from a group consisting of methanol, ethanol, isopropanol, dimethylformamide, methanoic acid, ethanoic acid, propanoic acid, butanoic acid, pentanoic acid and dimethylsulfoxide. At an ambient temperature typical for clean room environment, at which the wet treatment process will be carried out, the first liquid is typically soluble with the rinsing liquid. However, for propanoic acid, the temperature of the wet treatment process shall be maintained higher or equal to - 19.3 °C to obtain miscibility with the rinsing liquid.

In embodiments, exposure of the structure to the sequence may comprise bringing each of the liquids in the sequence into contact with a subsequent liquid. The subsequent liquid is miscible with the liquid, which precedes it in the sequence. This is advantageous since phase separation is avoided due to the miscibility, which otherwise could result in undesirable stiction.

Thus, upon introduction of a subsequent liquid in the sequence into the recipient, surface of the substrate is not exposed directly to the subsequent liquid since it is covered by the preceding liquid in the sequence that is already present in the recipient. Mixing of the preceding liquid with the subsequent liquid starts to take place thus, leading to a transition from the preceding liquid to the subsequent liquid. Due to the continuous flow of the subsequent liquid into the recipient, the concentration of the subsequent liquid gradually increases as a function of time, on the surface of the substrate, asymptotically from zero to its concentration upon introduction.

The preceding liquid is typically the liquid that is present in the overflow tank or the liquid that is being sprayed onto the structure at an arbitrary moment in time just before when it comes into contact with the subsequent liquid. It is further advantageous that thanks to the miscibility of the (preceding) liquid and the subsequent liquid, the (preceding) liquid may be gradually displaced from the over flow tank or from the spray tool, by the subsequent liquid.

Bringing each of the liquids in the sequence into contact with a subsequent liquid may be done by feeding the subsequent liquid into the inlet of the overflow tank, through which the (preceding) liquid has been flowing.

Feeding the subsequent liquid into the inlet may be done by similar ways as those aforementioned ways of bringing the first liquid in contact with the rinsing liquid.

In an over flow tank, during exposure of the structure to the sequence, while the structure remains fully covered with or fully immersed in the (preceding) liquid before the liquid comes into contact with the subsequent liquid, the structure begins to be fully covered with or fully immersed in the mixture of the (preceding) liquid with the subsequent liquid over time. This is due to the fact that at the time the subsequent liquid starts to flow into the tank a mixture will form due to miscibility of the (preceding) liquid and the subsequent liquid. The mixture will become rich in subsequent liquid as more subsequent liquid continuously flows into the over flow tank over time, where after sufficient time of flow of subsequent liquid, there will only be subsequent liquid passing through and getting discharged in the over flow tank, whereby the structure will be fully covered with or fully immersed in.

Thus, a continuous supply of subsequent liquid into the over flow tank or spray tool helps, on one hand, to keep the structure fully covered or fully immersed and, on the other hand, to gradually displace the (preceding) liquid from the wet treatment environment. It is advantageous that the structure remains fully covered or fully immersed during exposure to the sequence therefore avoiding contact with ambient thus, avoiding stiction problem.

In embodiments, the sequence may consist only of the first liquid and the last liquid. Having only these two liquids in the sequence may help to shorten the total time of the wet treatment process. This is due to the fact that the total time may be, to a certain degree, a function of the number of liquids in the sequence, volume of the wet cleaning environment, design of the wet treatment environment, flowrate of each of the liquids into the wet treatment environment, the time needed for each liquid in the sequence to reach 100 % volume in the tank while overflowing. Therefore, for a sequence consisting of two liquids, the total time will be reduced compared to a sequence that may consist of more liquids. This would result in a wet treatment process without stiction problem having a reduced cycle time and thus having an increased throughput.

It is an advantage that by using a first liquid and a last liquid in the sequence according to embodiments of the present invention, an efficient and a fast way of wet treatment of a structure may be obtained. A sequence consisting only of the first liquid and the last liquid may result in reduction of cycle time and thus increasing throughput of the wet treatment process.

Whether the last liquid shall be a polar solvent or a non-polar solvent may be determined by the surface characteristic of the second surface and the sidewall of the feature facing the second surface.

It is advantageous to tune the choice of the last liquid of the sequence according to the second surface and the sidewall being a polar or a non-polar material since it helps to avoid stiction problem. This is due to the fact that, stiction is related, in general, to the contact angle that the liquid makes with the surface. Contact angle is related to the similarity between the polarity of the surface and the polarity of the liquid that it is in contact with.

In embodiments, where at least the sidewall of the feature and the second surface is a polar material, the last liquid may be a non-polar solvent.

In embodiments, the complete surface of the feature that is exposed to the ambient and the second surface may be a polar material and consequently, the last liquid may be a non-polar solvent.

In embodiments, the feature and the second surface may be made of a polar material and consequently, the last liquid may be a non-polar solvent.

In embodiments, where the feature (10) may be located within a plurality of parallel features or may be one of the features located on either end of the plurality of features, the sidewalls of the features facing each other or the complete surface of the features or the features may be a polar material and consequently, the last liquid may be a non-polar solvent.

In embodiments, where the last liquid is a non-polar solvent, this non-polar solvent may be a hydrocarbon. This hydrocarbon may be an alkane, cycloalkane or an aromatic hydrocarbon compound consisting of carbon and hydrogen. These hydrocarbons have the potential to make a contact angle of about 90° with the second surface and the sidewall. In embodiments, this non-polar solvent may be chosen from a group consisting of heptane, hexane, pentane, benzene, cyclohexane, (2,2,4)-trimethylpentane and toluene.

In embodiments, the sequence may comprise two or more liquids including the first liquid and the last liquid.

In embodiments, the polar solvent forming the first liquid of the sequence may be isopropanol while the non-polar solvent of the last liquid of the sequence may be hexane. This is advantageous since isopropanol is miscible with the rinsing liquid, and hexane provides the desired non-stiction while completing the wet treatment.

In these embodiments, the sequence may consist of only the first liquid and the last liquid, thus only of isopropanol as the first liquid and hexane as the last liquid. This is advantageous since it provides performing wet treatment of structures without stiction. Furthermore, since only two liquids are involved in the sequence, cycle time for the wet treatment is shorter than the cycle time of another sequence involving more liquids for the same purpose.

Alternatively, in these embodiments, the sequence may consist only three liquids, whereby the first liquid is isopropanol and the last liquid is hexane and a third liquid is used in between these. The third liquid, in these embodiments, may be a ketone, an ester or a heterocyclic compound. In embodiments, the third liquid may be selected from a group consisting of acetone, ethyl acetate, methyl acetate and tetrahydrofuran. In preferred embodiments, the third liquid is ethyl acetate. This is advantageous since ethyl acetate permits for a better mixing with isopropanol and then better mixing with hexane when it is interposed between them in the sequence. Thus, it acts like an intermediate solvent facilitating faster miscibility and faster inter-mixing. It is beneficial that the composition of each of the liquids used in the sequence is uniform on every surface of the feature that it is exposed to during the wet treatment. This avoids the presence of asymmetry in composition of the liquid, thereby providing a balance on the cohesive forces exerted on the feature. This, then helps to overcome the stiction problem during drying after completion of the wet treatment. By allowing a faster miscibility and inter-mixing with isopropanol and hexane, ethyl acetate, therefore, helps to achieve easily a uniform composition on every surface of the feature that it is exposed to during the wet treatment. Without wishing to be bound by theory, this is related to the values of the different components of the cohesion energy of ethyl acetate in comparison to isopropanol and hexane, namely being the dispersive component (d), polar component (p) and hydrogen bonding (h). Ethyl acetate, thus facilitates miscibility and intermixing going from isopropanol to hexane in the sequence.

While, on the other hand, in embodiments, where at least the sidewall of the feature and the second surface is a non-polar material, the last liquid may be a polar solvent.

In embodiments at least the sidewall and the second surface is a non-polar material, for example, where it is a hydrophobic surface.

In embodiments, the complete surface of the feature that is exposed to the ambient and the second surface may be a non-polar material and consequently, the last liquid may be a polar solvent.

In embodiments, the feature and the second surface may be a non-polar material and consequently, the last liquid may be a polar solvent.

In embodiments, where the feature (10) may be located within a plurality of parallel features or may be one of the free-standing features located on either end of the plurality of free-standing features, the sidewalls of the features facing each other or the complete surface of the features or the features may be a non-polar material and consequently, the last liquid may be a polar solvent.

In embodiments, at least the sidewall of the feature and/or the second surface may comprise a metal, a dielectric or a semiconductor material.

In alternative embodiments, the complete surface of the feature and/or the second surface may comprise a metal, a dielectric or a semiconductor material.

In yet alternative embodiments, the feature and/or the second surface may comprise a metal, a dielectric or a semiconductor material.

In embodiments, the polar solvent of the last liquid may comprise water. In alternative embodiments, the polar solvent of the last liquid may consist only of water. Water may be de-ionized water. De-ionized water is readily available typically in cleanroom environments, where semiconductor manufacturing takes place.

We now refer to **Figure 1c.** Stiction problem originates from capillary forces when there is a thin layer of liquid between the surfaces of two features that face each other such that the thin layer of liquid can work as an adhesive. If the contact angle between the liquid and the surface is less than 90°, the pressure inside the liquid drop will be lower than outside and a net attractive force exists between the features. If the contact angle between the liquid and the surface is such that the pressure inside the liquid drop is higher than outside, a net repelling force exists between the features. This repelling force may end up with stiction of the neighboring features. The pressure difference $\Delta p_{la}$ at the liquid-air interface is given by the Laplace equation :

$$\Delta p_{la} = \frac{\gamma_{la}}{r} \qquad\qquad (Eq.\ 1)$$

where $\gamma_{la}$ is the surface tension of the liquid-air interface, and r is the radius of the curvature of the meniscus (12). The liquid (13) is between the features (10;11) and the liquid (13) contacts the surface (6) of the features at a fixed contact angle ($\theta$). From geometry it follows that;

$$r = -\frac{g}{2cos\theta} \qquad\qquad (Eq.\ 2)$$

In equilibrium, an external force (F) separating the features (10;11) must be applied to counterbalance the capillary pressure forces such that;

$$F = \Delta p_{la}A = \frac{2A\gamma_{la}cos\theta}{g} \qquad\qquad (Eq.\ 3)$$

where A is the wetted area. A positive value for F corresponds to a negative Laplace pressure. The pressure inside the liquid (13) is lower than outside and the features (10;11) are pushed together by pressure forces, thus causing stiction. Due to the fact that in equilibrium, an external force (F) separating the features must be applied to counterbalance the capillary pressure, a contact angle of about 90° is advantageous since it will make this force equal to zero thus avoiding stiction.

**Figure 1d** shows a tilted cross section Scanning Electron Microscopy (SEM) image of a structure (160) comprising fin structures (10) patterned in a silicon substrate (20), which face stiction problem observed after wet treatment process performed by using de-ionized water that is followed by drying. The fin structures (10) still possess the patterned hard mask (25) on their upper portion, which is typically deposited as a layer overlying the silicon substrate (20) before patterning in order to facilitate the etching process.

Such a stiction problem is generally observed during a wet treatment processing, where the structure is typically rinsed with de-ionized water followed by drying. By incorporating the sequence of liquids into the wet treatment process, as disclosed according to embodiments of the present invention, this stiction problem is avoided. Avoiding stiction problem has advantages on the yield of wet treatment processing such that the yield is increased. Increasing yield of process steps in semiconductor manufacturing is highly demanded particularly as feature sizes are getting smaller in order to compensate for high manufacturing costs.

**Claims**

1. A method for performing a wet treatment of a structure, the method comprising:

   - obtaining a structure (100,110,120,130,140,150) comprising a first surface (5,5',5") comprising a feature (10,11,30,40) fixed at least at a first end to the first surface (5,5',5") from which it protrudes, wherein a sidewall (6', 65, 75) of the feature (100,110,120,130,140,150) faces and is positioned away from a second surface (6,7,8) by a gap g,
   - performing a wet treatment of the structure, and;
   - subsequently, drying the structure,

   wherein performing the wet treatment comprises:

   - rinsing the structure (100,110,120,130,140,150) by exposing it to a rinsing liquid comprising water, and;
   - exposing the structure (100,110,120,130,140,150), subsequently, to a sequence of liquids, wherein a first liquid of the sequence is miscible with the rinsing liquid and wherein each of the liquids in the sequence is miscible with the preceding one, and whereby at least the first surface of the structure remains covered with the rinsing liquid until exposure to the sequence and with each liquid of the sequence until exposure to a subsequent liquid in the sequence
   - making a last liquid of the sequence have a contact angle of about 90° with the second surface (6,7,8) and the sidewall (6', 65, 75).

2. The method according to claim 1, wherein the wet treatment is performed at a pressure in the range of 0.5 bar to 2 bar and at a temperature in the range of 10 °C to 30 °C.

3. The method according to claim 1 or 2, wherein the exposure of the structure to the sequence is initiated by bringing the first liquid in contact with the rinsing liquid and subsequently, replacing the rinsing liquid, gradually, by the first liquid.

4. The method according to any of the preceding claims, wherein the exposure of the structure to the sequence comprises bringing a liquid in the sequence in contact with the subsequent liquid in the sequence and subsequently, replacing the liquid, gradually, by the subsequent liquid.

5. The method according to any one of the preceding claims, wherein;

   - the last liquid is a non-polar solvent when at least the sidewall and the second surface is a polar material, or;
   - the last liquid is a polar solvent when at least the sidewall and the second surface is a non-polar material.

6. The method according to claim 5, wherein the non-polar solvent is an alkane, cycloalkane or an aromatic hydrocarbon.

7. The method according to claims 5 or 6, wherein the non-polar solvent is selected from a group consisting of heptane, hexane, pentane, benzene, cyclohexane, (2,2,4)-trimethylpentane and toluene.

8. The method according to claim 5, wherein the polar solvent forming the last liquid comprises water.

9. The method according to any one of the preceding claims, wherein the first liquid is a polar solvent.

10. The method according to claim 9, wherein the polar solvent forming the first liquid is an alcohol, a carboxylic acid, an amide, an organosulfur compound or an organo-halogen compound.

11. The method according to claim 9 or 10, wherein the polar solvent of the first liquid is selected from a group consisting of methanol, ethanol, isopropanol, dimethylformamide, methanoic acid, ethanoic acid, propanoic acid, butanoic acid, pentanoic acid and dimethylsulfoxide.

12. The method according to any of the previous claims, wherein the wet treatment is performed in a single recipient.

13. The method according to claim 12, wherein the single recipient is a tank, whereby the structure remains immersed in the tank during the wet treatment.

14. The method according to claim 12, wherein, the wet treatment is performed, in the single recipient, by a spraying process.

15. The method according to any one of the preceding claims, wherein the sequence consists only of a first liquid and a last liquid.

16. The method according to any of the preceding claims, wherein the second surface (6) is a sidewall of another feature (11) protruding from the first surface (5).

**Patentansprüche**

1. Verfahren zur Durchführung einer Nassbehandlung einer Struktur, wobei das Verfahren umfasst:

   - Erhalten einer Struktur (100, 110, 120, 130, 140, 150), die eine erste Oberfläche (5, 5', 5") umfasst, die ein Merkmal (10, 11, 30, 40) umfasst, das zumindest an einem ersten Ende an der ersten Oberfläche (5,5',5") befestigt ist, aus der es hervorsteht, wobei eine Seitenwand (6', 65, 75) des Merkmals (100, 110, 120, 130, 140, 150) einer zweiten Oberfläche (6, 7, 8) zugewandt und durch einen Spalt g von dieser entfernt positioniert ist,
   - Durchführen einer Nassbehandlung der Struktur, und;
   - nachfolgendes Trocknen der Struktur,

wobei die Durchführung der Nassbehandlung umfasst:

- Spülen der Struktur (100, 110, 120, 130, 140, 150), indem sie einer Wasser umfassenden Spülflüssigkeit ausgesetzt wird, und;
- nachfolgendes Aussetzen der Struktur (100, 110, 120, 130, 140, 150) einer Sequenz von Flüssigkeiten, wobei eine erste Flüssigkeit der Sequenz mit der Spülflüssigkeit mischbar ist und wobei jede der Flüssigkeiten in der Sequenz mit der vorhergehenden mischbar ist, und wobei zumindest die erste Oberfläche der Struktur mit der Spülflüssigkeit bedeckt bleibt, bis sie der Sequenz ausgesetzt wird, und mit jeder Flüssigkeit der Sequenz, bis sie einer nachfolgenden Flüssigkeit in der Sequenz ausgesetzt wird
- wodurch eine letzte Flüssigkeit der Sequenz einen Kontaktwinkel von etwa 90° mit der zweiten Oberfläche (6, 7, 8) und der Seitenwand (6', 65, 75) aufweist.

2. Verfahren nach Anspruch 1, wobei die Nassbehandlung bei einem Druck in dem Bereich von 0,5 bar bis 2 bar und bei einer Temperatur in dem Bereich von 10 °C bis 30 °C durchgeführt wird.

3. Verfahren nach Anspruch 1 oder 2, wobei das Aussetzen der Struktur der Sequenz eingeleitet wird, indem die erste Flüssigkeit mit der Spülflüssigkeit in Kontakt gebracht wird und nachfolgend die Spülflüssigkeit nach und nach durch die erste Flüssigkeit ersetzt wird.

4. Verfahren nach einem der vorstehenden Ansprüche, wobei das Aussetzen der Struktur der Sequenz das Inkontaktbringen einer Flüssigkeit in der Sequenz mit der nachfolgenden Flüssigkeit in der Sequenz und das nachfolgende allmähliche Ersetzen der Flüssigkeit durch die nachfolgende Flüssigkeit umfasst.

5. Verfahren nach einem der vorstehenden Ansprüche, wobei;

- die letzte Flüssigkeit ein unpolares Lösungsmittel ist, wenn mindestens die Seitenwand und die zweite Oberfläche ein polares Material ist, oder;
- die letzte Flüssigkeit ein polares Lösungsmittel ist, wenn mindestens die Seitenwand und die zweite Oberfläche ein unpolares Material ist.

6. Verfahren nach Anspruch 5, wobei das unpolare Lösungsmittel ein Alkan, Cycloalkan oder ein aromatischer Kohlenwasserstoff ist.

7. Verfahren nach Anspruch 5 oder 6, wobei das unpolare Lösungsmittel ausgewählt ist aus einer Gruppe bestehend aus Heptan, Hexan, Pentan, Benzol, Cyclohexan, (2,2,4)-Trimethylpentan und Toluol.

8. Verfahren nach Anspruch 5, wobei das polare Lösungsmittel, das die letzte Flüssigkeit bildet, Wasser umfasst.

9. Verfahren nach einem der vorstehenden Ansprüche, wobei die erste Flüssigkeit ein polares Lösungsmittel ist.

10. Verfahren nach Anspruch 9, wobei das polare Lösungsmittel, das die erste Flüssigkeit bildet, ein Alkohol, eine Carbonsäure, ein Amid, eine schwefelorganische Verbindung oder eine halogenorganische Verbindung ist.

11. Verfahren nach Anspruch 9 oder 10, wobei das polare Lösungsmittel der ersten Flüssigkeit ausgewählt ist aus einer Gruppe bestehend aus Methanol, Ethanol, Isopropanol, Dimethylformamid, Methansäure, Ethansäure, Propansäure, Butansäure, Pentansäure und Dimethylsulfoxid.

12. Verfahren nach einem der vorstehenden Ansprüche, wobei die Nassbehandlung in einem einzelnen Behälter durchgeführt wird.

13. Verfahren nach Anspruch 12, wobei der einzelne Behälter ein Tank ist, wobei die Struktur während der Nassbehandlung in den Tank eingetaucht bleibt.

14. Verfahren nach Anspruch 12, wobei die Nassbehandlung in dem einzelnen Behälter durch ein Sprühverfahren durchgeführt wird.

15. Verfahren nach einem der vorstehenden Ansprüche, wobei die Sequenz nur aus einer ersten Flüssigkeit und einer letzten Flüssigkeit besteht.

**16.** Verfahren nach einem der vorstehenden Ansprüche, wobei die zweite Oberfläche (6) eine Seitenwand eines anderen Merkmals (11) ist, das aus der ersten Oberfläche (5) hervorsteht.

**Revendications**

**1.** Procédé de réalisation d'un traitement humide d'une structure, le procédé comprenant:

- l'obtention d'une structure (100, 110, 120, 130, 140, 150) comprenant une première surface (5, 5', 5") comprenant un élément (10, 11, 30, 40) fixé au moins au niveau d'une première extrémité à la première surface (5, 5', 5") à partir de laquelle il fait saillie, dans lequel une paroi latérale (6', 65, 75) de l'élément (100, 110, 120, 130, 140, 150) est face à et est positionnée à distance d'une seconde surface (6, 7, 8) par un espace g,
- la réalisation d'un traitement humide de la structure, et ;
- ensuite, le séchage de la structure,

dans lequel la réalisation du traitement humide comprend :

- le rinçage de la structure (100, 110, 120, 130, 140, 150) par exposition de celle-ci à un liquide de rinçage comprenant de l'eau, et ;
- l'exposition de la structure (100, 110, 120, 130, 140, 150), ensuite, à une séquence de liquides, dans lequel un premier liquide de la séquence est miscible au liquide de rinçage et dans lequel chacun des liquides dans la séquence est miscible au précédent, et moyennant quoi au moins la première surface de la structure reste recouverte du liquide de rinçage jusqu'à exposition à la séquence et de chaque liquide de la séquence jusqu'à exposition à un liquide suivant dans la séquence
- le fait de faire en sorte qu'un dernier liquide de la séquence présente un angle de contact d'environ 90° avec la seconde surface (6, 7, 8) et la paroi latérale (6', 65, 75).

**2.** Procédé selon la revendication 1, dans lequel le traitement humide est effectué à une pression dans la plage de 0,5 bar à 2 bar et à une température dans la plage de 10 °C à 30 °C.

**3.** Procédé selon la revendication 1 ou 2, dans lequel l'exposition de la structure à la séquence est démarrée en amenant le premier liquide en contact avec le liquide de rinçage et ensuite, en remplaçant le liquide de rinçage, progressivement, par le premier liquide.

**4.** Procédé selon l'une quelconque des revendications précédentes, dans lequel l'exposition de la structure à la séquence comprend le fait d'amener un liquide dans la séquence en contact avec le liquide suivant dans la séquence et ensuite, le remplacement du liquide, progressivement, par le liquide suivant.

**5.** Procédé selon l'une quelconque des revendications précédentes, dans lequel ;

- le dernier liquide est un solvant non polaire lorsqu'au moins la paroi latérale et la seconde surface est un matériau polaire, ou ;
- le dernier liquide est un solvant polaire lorsqu'au moins la paroi latérale et la seconde surface est un matériau non polaire.

**6.** Procédé selon la revendication 5, dans lequel le solvant non polaire est un alcane, un cycloalcane ou un hydrocarbure aromatique.

**7.** Procédé selon les revendications 5 ou 6, dans lequel le solvant non polaire est choisi dans un groupe constitué d'heptane, d'hexane, de pentane, de benzène, de cyclohexane, de (2,2,4)-triméthylpentane et de toluène.

**8.** Procédé selon la revendication 5, dans lequel le solvant polaire formant le dernier liquide comprend de l'eau.

**9.** Procédé selon l'une quelconque des revendications précédentes, dans lequel le premier liquide est un solvant polaire.

**10.** Procédé selon la revendication 9, dans lequel le solvant polaire formant le premier liquide est un alcool, un acide carboxylique, un amide, un composé organosulfuré ou un composé organohalogéné.

**11.** Procédé selon la revendication 9 ou 10, dans lequel le solvant polaire du premier liquide est choisi dans un groupe constitué de méthanol, d'éthanol, d'isopropanol, de diméthylformamide, d'acide méthanoïque, d'acide éthanoïque, d'acide propanoïque, d'acide butanoïque, d'acide pentanoïque et de diméthylsulfoxyde.

**12.** Procédé selon l'une quelconque des revendications précédentes, dans lequel le traitement humide est effectué dans un récipient unique.

**13.** Procédé selon la revendication 12, dans lequel le récipient unique est une cuve, moyennant quoi la structure reste immergée dans la cuve pendant le traitement humide.

**14.** Procédé selon la revendication 12, dans lequel le traitement humide est effectué, dans le récipient unique, par un procédé de pulvérisation.

**15.** Procédé selon l'une quelconque des revendications précédentes, dans lequel la séquence est uniquement constituée d'un premier liquide et d'un dernier liquide.

**16.** Procédé selon l'une quelconque des revendications précédentes, dans lequel la seconde surface (6) est une paroi latérale d'un autre élément (11) faisant saillie à partir de la première surface (5).

1000

100

Obtaining a structure

400

Performing a wet
treatment of the structure

500

Drying the structure

Fig. 1a

400

200

Rinsing the structure with a
rinsing liquid

300

Exposing the structure to a
sequence of cleaning
liquids

Fig. 1b

Fig. 1c

Fig. 1d

Fig. 2a

Fig. 2b

**120**

l

15    5'    30    65    W    7

g

20

Fig. 3a

**130**

l

15    5'    30    65    W    7

g

21

Fig. 3b

**140**

75

l

16    5''    40    5'''    W    16'

g    8

20

Fig. 4a

**150**

75

l

16    5''    40    5'''    W    16'

g    8

21

Fig. 4b

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20140144462 A1
- US 20100122711 A1
- US 20130081301 A1